# EUROPEAN PATENT APPLICATION

(11) **EP 4 848 909 A1**
(43) Date of publication of application: **02.12.2026**
(21) Application number: 25745182.3
(22) Date of filing: 23.01.2025
(51) Int. Cl.: H05K 1/05, C08G 59/62, C08K 3/013, C08L 63/00, H05K 1/02, H05K 3/44

(54) **THERMALLY CONDUCTIVE SHEET**

(30) Priority: 25.01.2024 JP 2024009623
(71) Applicant: Denka Company Limited, Tokyo 103-8338 (JP)
(72) Inventor: MIYOSHI, Rio, Tokyo 103-8338 (JP); KUMAGAI, Ryota, Tokyo 103-8338 (JP); ICHIKAWA, Isamu, Tokyo 103-8338 (JP); NEBASHI, Ibuki, Tokyo 103-8338 (JP)
(74) Representative: Hoffmann Eitle
(86) International application number: PCT/JP2025/001984
(87) International publication number: WO 2025/159139

(57) **Abstract**

A thermally conductive sheet having an epoxy resin A having a predetermined repeating unit and a thermally conductive filler.

## Description

### Technical Field

The present invention relates to a thermally conductive sheet.

### Background Art

Various circuit boards have been put into practical use as circuit boards for mounting electronic and electrical components including semiconductor elements to form hybrid integrated circuits. Circuit boards are classified into resin circuit boards, ceramic circuit boards, metal base circuit boards, and the like based on the substrate material.

Resin circuit boards are inexpensive but have low thermal conductivity, and are therefore limited to applications used with relatively low power. Ceramic circuit boards are suitable for applications used with relatively high power due to the characteristics of ceramics, such as high insulation reliability and heat resistance, but have the drawback of being expensive. On the other hand, metal base circuit boards have properties intermediate between the two, and are suitable for general-purpose applications used with relatively high power, such as inverters for refrigerators, inverters for commercial air conditioners, power supplies for industrial robots, and power supplies for automobiles.

For example, Patent Document 1 discloses, as a laminate for a metal base circuit board having a structure in which two metal layers are bonded by an insulating layer, a laminate in which the surface roughness of the metal layer bonded to the insulating layer is defined, with the aim of solving the problem of decreased adhesion reliability of the insulating layer in high-temperature processing.

### Citation List

### Patent Literature

Patent Document 1: Japanese Patent Laid-Open No. 2022-173751

### Summary of the Invention

### Technical Problem

Now, if a ceramic circuit board could be replaced with a metal base circuit board, improvements in productivity could be expected. In addition, ceramic circuit boards have the problem of susceptibility to solder cracking on the board during heat cycling; however, by replacing them with metal base circuit boards, suppression of solder cracking can be expected. On the other hand, in the industrial module field and the like where ceramic circuit boards are used, high-temperature processing such as solder reflow processing is performed; however, with conventional metal base circuit boards, the adhesion reliability of the insulating layer that bonds the metal layers may decrease after high-temperature processing. For this reason, an insulating thermally conductive sheet having a high glass transition temperature that can be used as the insulating layer of the laminate for metal base circuit boards has been desired.

The present invention has been made in view of the above-mentioned problems, and an object thereof is to provide an insulating thermally conductive sheet capable of giving a cured product having a high glass transition temperature.

### Solution to Problem

The inventors of the present invention have conducted intensive studies to solve the above-mentioned problems. As a result, they found that the above-mentioned problems can be solved by using a predetermined epoxy resin, and thereby completed the present invention.

That is, the present invention is as follows.
[1] A thermally conductive sheet comprising:
   an epoxy resin A having a repeating unit represented by the following formula (1); and
   a thermally conductive filler, 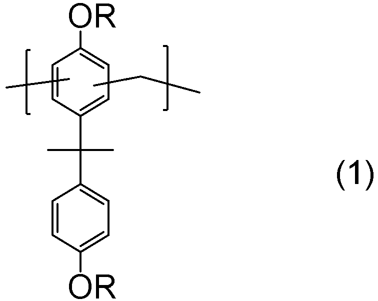
   wherein R each independently represents a hydrogen atom or a group represented by the following formula (2), and at least one R represents a group represented by the following formula (2). 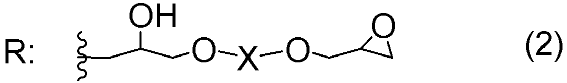
   wherein X represents a divalent aryl group or a divalent bisphenol skeleton.
[2] The thermally conductive sheet according to [1], wherein R is represented by the following formula (2a). 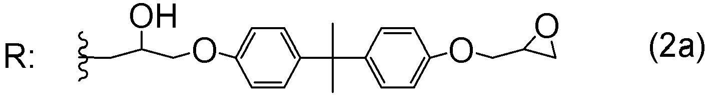
[3] The thermally conductive sheet according to [1], wherein the epoxy equivalent a of the epoxy resin A is from 170 to 195 g/eq.
[4] The thermally conductive sheet according to [1], wherein the OH equivalent b of the epoxy resin A is from 100 to 120 g/eq.
[5] The thermally conductive sheet according to [1], wherein the ratio (b/a) of the OH equivalent b to the epoxy equivalent a of the epoxy resin A is from 0.15 to 0.90.
[6] The thermally conductive sheet according to [1], wherein the thermally conductive filler comprises a boron nitride aggregate.
[7] A laminate comprising:
   a first metal layer;
   an insulating layer disposed on the first metal layer; and
   a second metal layer disposed on the insulating layer,
   wherein the insulating layer comprises the thermally conductive sheet according to any one of [1] to [6].
[8] A method for producing a laminate, comprising:
   a step of preparing the thermally conductive sheet according to any one of [1] to [6]; and
   a step of obtaining a laminate by press-heating the thermally conductive sheet while sandwiching the thermally conductive sheet between a metal foil and a metal substrate.
[9] A circuit board comprising:
   a first metal layer;
   an insulating layer disposed on the first metal layer; and
   a second metal layer disposed on the insulating layer,
   wherein the insulating layer comprises the thermally conductive sheet according to any one of [1] to [6], and
   the second metal layer is a circuit portion.
[10] A method for producing a circuit board, comprising:
   a step of preparing the laminate according to [7]; and
   a step of forming a circuit portion by removing part of the first metal layer or part of the second metal layer of the laminate.

### Advantageous Effect of Invention

According to the present invention, it is possible to provide an insulating thermally conductive sheet capable of giving a cured product having a high glass transition temperature.

### Brief Description of Drawings

[FIG. 1] A cross-sectional view showing a laminate for a metal base circuit board according to the present embodiment.
[FIG. 2] A cross-sectional view showing a laminate for a metal core circuit board according to the present embodiment.
[FIG. 3] A cross-sectional view showing a circuit board according to the present embodiment.

### Description of Embodiment

Hereinafter, an embodiment of the present invention (hereinafter referred to as "the present embodiment") will be described in detail; however, the present invention is not limited thereto, and various modifications can be made without departing from the gist thereof.

### 1. Thermally Conductive Sheet

The thermally conductive sheet of the present embodiment comprises an epoxy resin A having a repeating unit represented by the following formula (1) and a thermally conductive filler, and may optionally comprise a curing agent, a curing accelerator, an ion scavenger, a solvent, and a surfactant. Each component will be described in detail below. 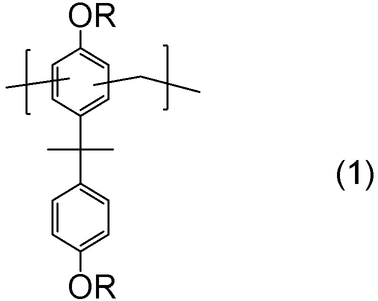 wherein R each independently represents a hydrogen atom or a group represented by the following formula (2), and at least one R represents a group represented by the following formula (2) .) 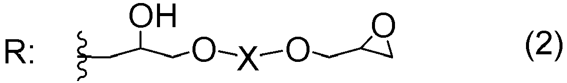 wherein X represents a divalent aryl group or a divalent bisphenol skeleton.

In addition, the thermally conductive sheet of the present embodiment is preferably in the B-stage. This allows the thermally conductive sheet to be excellent in handleability as a sheet, and to be further cured by sandwiching it between a metal plate and a metal layer and press-heating, whereby the sheet becomes an insulating layer having thermal conductivity and heat resistance.

In the present embodiment, "B-stage" means, in accordance with JIS K6900:1994, an intermediate stage in the reaction of certain thermosetting resins where the material swells when contacted with certain liquids and softens when heated, but does not completely dissolve or melt. In addition, "A-stage" in contrast to B-stage means an early stage in the preparation of certain thermosetting resins where the material is still soluble in certain liquids and is fusible. Furthermore, "C-stage" means the final stage in the reaction of certain thermosetting resins where the material becomes virtually insoluble and infusible. The resin of a completely cured thermosetting molded article is at the C-stage.

The fact that the thermally conductive sheet is in the B-stage state can also be evaluated by the degree of cure of the thermally conductive sheet. In the present embodiment, the B-stage state means that the degree of cure of the thermally conductive sheet is preferably from 20 to 80%, from 30 to 70%, and from 40 to 60%. The degree of cure is a value representing the amount of heat generated until reaching the semi-cured (B-stage) state, with the total heat generated from the uncured state to the fully cured state taken as 100%. The degree of cure can be determined using a thermal analysis instrument such as a differential scanning calorimeter.

### 1.1. Epoxy Resin A

In the present embodiment, the thermally conductive sheet contains an epoxy resin A having a repeating unit represented by the above formula (1). Examples of such epoxy resin A include, without particular limitation, compounds in which at least some of the hydrogen atoms of the hydroxyl groups of a bisphenol A-type novolac resin represented by the following formula (1') are substituted with a group represented by formula (2). By comprising such epoxy resin A, the glass transition temperature of the resulting cured product tends to be further improved. 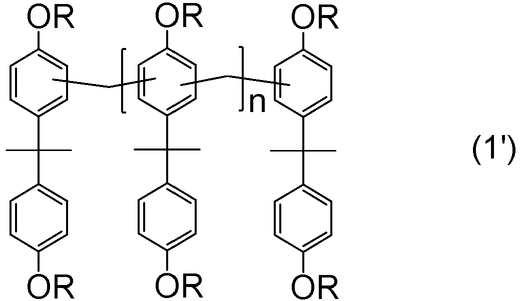 wherein R each independently represents a hydrogen atom or a group represented by the following formula (2), and at least one R represents a group represented by the following formula (2), and n represents an integer of 1 to 10.

In the above formula (1) or (1'), R each independently represents a hydrogen atom or a group represented by the following formula (2), and at least one R represents a group represented by the following formula (2).

In the above formula (2), examples of X include: divalent aryl groups such as a phenylene group, a naphthylene group, and an anthracenyl group; and divalent bisphenol skeletons derived from bisphenol A, bisphenol AP, bisphenol AF, bisphenol B, bisphenol BP, bisphenol C, bisphenol E, bisphenol F, bisphenol G, bisphenol M, bisphenol S, bisphenol P, bisphenol PH, bisphenol TMC, and bisphenol Z.

Among these, a divalent bisphenol skeleton is preferred, and it is more preferred that epoxy resin A comprise at least a repeating unit represented by the following formula (2a) having a divalent bisphenol skeleton derived from bisphenol A. Having such a side chain tends to further improve the glass transition temperature, insulation reliability, and peel strength. In addition, by comprising the repeating unit represented by formula (2a), deterioration over time of peel strength and insulation reliability at normal temperature and low temperature tends to be suppressed, and storage stability tends to be further improved.

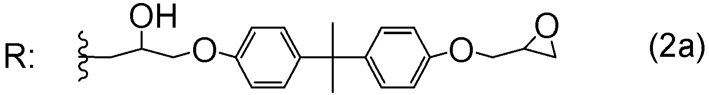

Note that the "divalent bisphenol skeleton" means a residue of bisphenol excluding the two hydroxyl groups. Accordingly, the "divalent bisphenol skeleton derived from bisphenol A" refers to the structure represented by the following formula.

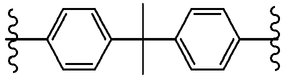

Among the above, epoxy resin A is preferably one in which the skeleton other than the R group in the repeating unit represented by formula (1) is derived from bisphenol A-type novolac resin A1, and the R group represented by formula (2) is derived from epoxy resin A2 having a divalent aryl group or a divalent bisphenol skeleton. This tends to further improve the glass transition temperature, insulation reliability, and peel strength, as well as to suppress deterioration over time of peel strength and insulation reliability at normal temperature and low temperature, thereby further improving storage stability.

The epoxy equivalent a of epoxy resin A2 is preferably 130 g/eq or more, 140 g/eq or more, 150 g/eq or more, 160 g/eq or more, and 170 g/eq or more. In addition, the epoxy equivalent a of epoxy resin A is preferably 205 g/eq or less, 200 g/eq or less, 195 g/eq or less, and 190 g/eq or less. When the epoxy equivalent a is within the above range, the glass transition temperature of the resulting cured product tends to be further improved.

The OH equivalent b of bisphenol A-type novolac resin A1 is preferably from 90 to 135 g/eq, from 95 to 130 g/eq, from 100 to 125 g/eq, and from 100 to 120 g/eq. When the OH equivalent b is within the above range, the glass transition temperature of the resulting cured product tends to be further improved.

The ratio (b/a) of the OH equivalent b of bisphenol A-type novolac resin A1 to the epoxy equivalent a of epoxy resin A2 is preferably 0.05 or more, 0.10 or more, 0.15 or more, 0.20 or more, 0.25 or more, and 0.35 or more. In addition, the ratio (b/a) is preferably 0.95 or less, 0.85 or less, 0.80 or less, 0.75 or less, 0.70 or less, and 0.65 or less. When the ratio (b/a) is within the above range, the glass transition temperature of the resulting cured product tends to be further improved.

The weight-average molecular weight of epoxy resin A is preferably from 300 to 2,000, from 300 to 1,500, from 300 to 1,000, from 400 to 900, and from 500 to 850. When the weight-average molecular weight of epoxy resin A is within the above range, the glass transition temperature of the resulting cured product tends to be further improved.

The content of epoxy resin A is preferably from 50 to 95 parts by mass, from 55 to 90 parts by mass, from 60 to 87.5 parts by mass, and from 62.5 to 85 parts by mass, relative to 100 parts by mass of the resin component of the thermally conductive sheet. When the content of epoxy resin A is within the above range, the glass transition temperature of the resulting cured product tends to be further improved.

In the present embodiment, "resin component" refers to the amount of components excluding the thermally conductive filler and solvent.

### 1.2. Thermally Conductive Filler

The thermally conductive filler is not particularly limited, and examples thereof include boron nitride, aluminum nitride, aluminum oxide, silicon nitride, silicon oxide, magnesium oxide, metallic aluminum, and zinc oxide.

Among these, boron nitride is preferred, and a boron nitride aggregate is more preferred. Here, "boron nitride aggregate" refers to aggregated particles formed by aggregation of primary particles of boron nitride. Using such a thermally conductive filler tends to further improve thermal conductivity and insulation reliability.

The average particle diameter of the thermally conductive filler is preferably from 10 to 100 µm, from 20 to 80 µm, from 25 to 70 µm, and from 30 to 60 µm. When the average particle diameter of the thermally conductive filler is 10 µm or more, high thermal conductivity tends to be achievable with a smaller amount. When the average particle diameter of the thermally conductive filler is 25 µm or more, insulation reliability and peel strength with respect to the metal layer tend to be further improved. When the average particle diameter of the thermally conductive filler is 100 µm or less, the viscosity tends to decrease, and entrainment of air bubbles during sheet molding tends to decrease. Consequently, partial discharge due to air bubbles tends to decrease, concentration of electric field tends to be less likely to occur, and insulation performance tends to be further improved.

When the thermally conductive filler is an aggregated particle formed by aggregation of primary particles, the average particle diameter means the particle diameter of the aggregated particle. The particle diameter of the aggregated particle is also referred to as the secondary particle diameter.

In the present embodiment, the average particle diameter of the thermally conductive filler means the particle diameter at the 50% point of the cumulative particle size distribution. The average particle diameter of the thermally conductive filler can be measured by a laser diffraction/light scattering method. An example of a particle size distribution analyzer is "MT3300EX" (manufactured by Nikkiso Co., Ltd.). For the measurement, water is used as the solvent and hexametaphosphoric acid is used as the dispersant; as a pretreatment, dispersion treatment is performed at an output of 20 W using a homogenizer for 30 seconds. A refractive index of 1.33 is used for water. When the measurement target is boron nitride powder, a refractive index of 1.80 can be used. The measurement time per run is not particularly limited, but is, for example, 30 seconds.

The content of the thermally conductive filler is preferably from 25 to 55 vol%, from 30 to 50 vol%, and from 35 to 45 vol%, relative to the total amount of the thermally conductive sheet. When the content of the thermally conductive filler is 25 vol% or more, the thermal conductivity tends to be further improved by the action of the thermally conductive filler. When the content of the thermally conductive filler is 55 vol% or less, voids and the like tend to be less likely to occur, and thermal conductivity and insulation reliability tend to be further improved.

### 1.3. Other Epoxy Resin B

The thermally conductive sheet of the present embodiment may comprise an epoxy resin other than epoxy resin A (hereinafter referred to as "epoxy resin B" for convenience).

Epoxy resin B is not particularly limited, and examples thereof include bisphenol A-type epoxy resin, bisphenol AP-type epoxy resin, bisphenol AF-type epoxy resin, bisphenol B-type epoxy resin, bisphenol BP-type epoxy resin, bisphenol C-type epoxy resin, bisphenol E-type epoxy resin, bisphenol F-type epoxy resin, bisphenol G-type epoxy resin, bisphenol M-type epoxy resin, bisphenol S-type epoxy resin, bisphenol P-type epoxy resin, bisphenol PH-type epoxy resin, bisphenol TMC-type epoxy resin, bisphenol Z-type epoxy resin, polypropylene glycol-type epoxy resin, polytetramethylene glycol-type epoxy resin, naphthalene-type epoxy resins such as 1,6-naphthalenediol-type epoxy resin, anthracene-type epoxy resins such as 9,10-anthracenediol-type epoxy resin, phenylmethane-type epoxy resin, tetrakisphenolmethane-type epoxy resin, biphenyl-type epoxy resin, epoxy resins having a triazine skeleton, and bisphenol A alkylene oxide adduct-type epoxy resins.

### 1.4. Curing Agent

The thermally conductive sheet of the present embodiment may comprise a curing agent. The curing agent is not particularly limited, and examples thereof include phenol-based curing agents, amine-based curing agents, acid anhydride-based curing agents, and thiol-based curing agents.

Phenol-based curing agents include, without particular limitation, phenol novolac, xylylene novolac, and bisphenol A-type novolac.

Amine-based curing agents include, without particular limitation, aromatic amine-based curing agents, aliphatic amine-based curing agents, and dicyandiamide.

Acid anhydride-based curing agents include, without particular limitation, aliphatic acid anhydrides such as phthalic anhydride derivatives, and aromatic acid anhydrides such as maleic anhydride.

Thiol-based curing agents include, without particular limitation, aliphatic polythioethers, aliphatic polythioesters, and aromatic-containing polythioethers.

The content of the curing agent is preferably from 2.5 to 30 parts by mass, from 5.0 to 25 parts by mass, from 7.5 to 20 parts by mass, and from 10 to 15 parts by mass, relative to 100 parts by mass of the resin component of the thermally conductive sheet. When the content of the curing agent is 2.5 parts by mass or more, the glass transition temperature and strength of the B-stage sheet tend to be further improved. When the amount of the curing agent used is 30 parts by mass or less, embrittlement due to the B-stage sheet becoming too hard tends to be further suppressed.

### 1.5. Curing Accelerator

The thermally conductive sheet of the present embodiment may comprise a curing accelerator for epoxy resin A. Note that while the curing agent forms the main skeleton of the cured product, the curing accelerator does not form the main skeleton of the cured product but contributes to the curing rate and curing temperature.

Such curing accelerators include, without particular limitation, imidazole-based curing accelerators and phosphorus-based curing accelerators.

Imidazole-based curing accelerators include, without particular limitation, 2-methylimidazole, 2-ethylimidazole, 2-undecylimidazole, 2,4-dimethylimidazole, 2-heptadecylimidazole, 1,2-dimethylimidazole, 1,2-diethylimidazole, 2-phenyl-4-methylimidazole, 2,4,5-triphenylimidazole, 2-ethyl-4-methylimidazole, 2-phenylimidazole, 1-benzyl-2-phenylimidazole, 1-cyanoethyl-2-methylimidazole, 1-cyanoethyl-2-undecylimidazole, 1-benzyl-2-methylimidazole, 2-phenyl-4,5-dihydroxymethylimidazole, 2,3-dihydro-1H-pyrrolo[1,2-a]benzimidazole, 2-aryl-4,5-diphenylimidazole, 2,4-diamino-6-[2'-methylimidazolyl-(1')]-ethyl-S-triazine, 2,4-diamino-6-[2'-ethyl-4'-methylimidazolyl-(1')]-ethyl-S-triazine, 2,4-diamino-6-[2'-methylimidazolyl-(1')]-ethyl-S-triazine isocyanuric acid adduct, and 2-phenyl-4-methyl-5-hydroxymethylimidazole.

Phosphorus-based curing accelerators include, without particular limitation, tetraphenylphosphonium tetra-p-tolylborate, tetraphenylphosphonium tetraphenylborate, triphenylphosphine, tri-p-tolylphosphine, tris(4-chlorophenyl)phosphine, tris(2,6-dimethoxyphenyl)phosphine, triphenylphosphine triphenylborane, tetraphenylphosphonium dicyanamide, and tetraphenylphosphonium tetra(4-methylphenyl)borate.

Among these, combined use of a phosphorus-based curing accelerator and an imidazole-based curing accelerator is preferred. This tends to further improve curability and the glass transition temperature of the resulting cured product.

The content of the phosphorus-based curing accelerator is preferably from 0.01 to 2.5 parts by mass, from 0.03 to 1.5 parts by mass, from 0.05 to 0.80 parts by mass, and from 0.10 to 0.60 parts by mass, relative to 100 parts by mass of the resin component of the thermally conductive sheet. When the content of the phosphorus-based curing accelerator is within the above range, the glass transition temperature and strength of the B-stage sheet tend to be further improved.

The content of the imidazole-based curing accelerator is preferably from 0.01 to 2.5 parts by mass, from 0.03 to 1.5 parts by mass, from 0.05 to 0.80 parts by mass, and from 0.10 to 0.60 parts by mass, relative to 100 parts by mass of the resin component of the thermally conductive sheet. When the content of the imidazole-based curing accelerator is within the above range, embrittlement due to the B-stage sheet becoming too hard tends to be further suppressed.

The ratio of the content of the imidazole-based curing accelerator to the content of the phosphorus-based curing accelerator is preferably from 0.50 to 2.00 parts by mass, from 0.65 to 1.50 parts by mass, and from 0.80 to 1.25 parts by mass. When the ratio of the content of the imidazole-based curing accelerator to the content of the phosphorus-based curing accelerator is within the above range, the glass transition temperature and strength of the B-stage sheet tend to be further improved, and embrittlement due to the B-stage sheet becoming too hard tends to be further suppressed.

The total content of the curing accelerator is preferably from 0.01 to 10 parts by mass, from 0.03 to 7.5 parts by mass, from 0.05 to 5.0 parts by mass, from 0.10 to 2.5 parts by mass, and from 0.15 to 1.5 parts by mass, relative to 100 parts by mass of the resin component of the thermally conductive sheet. When the total content of the curing accelerator is 0.01 parts by mass or more, the glass transition temperature and strength of the B-stage sheet tend to be further improved. When the total content of the curing accelerator is 10 parts by mass or less, embrittlement due to the B-stage sheet becoming too hard tends to be further suppressed.

### 1.6. Ion Scavenger

The ion scavenger is not particularly limited, and examples thereof include conventionally known ion scavengers such as hydrotalcite.

The content of the ion scavenger is preferably from 0.01 to 3.5 parts by mass, from 0.10 to 2.5 parts by mass, and from 0.50 to 1.5 parts by mass, relative to 100 parts by mass of the resin component of the thermally conductive sheet.

### 1.7. Solvent

The composition before producing the thermally conductive sheet may comprise a solvent. The solvent is not particularly limited, and examples thereof include alcohol-based solvents, glycol ether-based solvents, aromatic solvents, and ketone-based solvents. Examples of alcohol-based solvents include isopropyl alcohol and diacetone alcohol. Examples of glycol ether-based solvents include ethyl cellosolve and butyl cellosolve. Examples of aromatic solvents include toluene and xylene. Examples of ketone-based solvents include methyl ethyl ketone and methyl isobutyl ketone.

### 1.8. Surfactant

The surfactant is not particularly limited as long as it improves the dispersibility of the thermally conductive filler. Examples of the surfactant include copolymers having a (meth)acrylic monomer unit α having an anionic group, a (meth)acrylic monomer unit β having a cationic group, and a silicone (meth)acrylic monomer unit γ. Using such a surfactant tends to further improve the dispersibility of the thermally conductive filler.

The amount of the surfactant used is preferably from 0.01 to 10 parts by mass, from 0.02 to 8 parts by mass, and from 0.03 to 6 parts by mass, relative to 100 parts by mass of the resin component of the thermally conductive sheet. When the amount of the surfactant used is within the above range, dispersibility tends to be further improved.

### 2. Laminate

The laminate of the present embodiment comprises a first metal layer, an insulating layer disposed on the first metal layer, and a second metal layer disposed on the insulating layer, wherein the insulating layer comprises the thermally conductive sheet described above. In this state, the thermally conductive sheet may be in the A-stage state due to press-heating in the production process of the laminate.

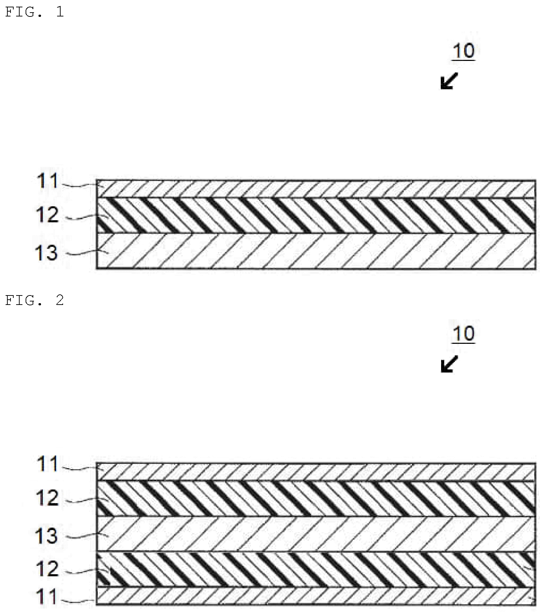

FIG. 1 shows a cross-sectional view of a laminate for a metal base circuit board according to the present embodiment. As shown in FIG. 1, in one embodiment of the laminate 10 of the present embodiment, the thermally conductive sheet 12 serving as an insulating layer and the second metal layer 11 are provided in this order on one surface of the first metal layer 13 serving as the base.

FIG. 2 shows a cross-sectional view of a laminate for a metal core circuit board according to the present embodiment. As shown in FIG. 2, in another embodiment of the laminate 10 of the present embodiment, the thermally conductive sheet 12 serving as an insulating layer and the second metal layer 11 are provided in this order on both surfaces of the first metal layer 13 serving as the core. Hereinafter, when the metal base circuit board and the metal core circuit board are not particularly distinguished, each is simply referred to as a "circuit board."

In this way, by using the first metal layer 13 as the base or core, heat generated by electronic components mounted on the second metal layer 11 can be conducted to a casing or heat sink through the thermally conductive sheet 12. The thermally conductive sheet used in such a laminate is required to have high insulation properties and high heat resistance.

The first metal layer serves as the base or core of the circuit board. The metal material constituting the first metal layer is not particularly limited, and examples thereof include aluminum, copper, iron, silver, gold, zinc, nickel, tin, and alloys containing these metals. Among these, aluminum, copper, and iron are preferred. Using such metal materials can improve heat dissipation and can further reduce the coefficient of thermal expansion of the laminate.

The thickness of the first metal layer varies depending on whether it serves as the base or core, but is preferably from 0.01 to 10 mm, from 0.1 to 5.0 mm, and from 1.0 to 3.0 mm.

The second metal layer serves as the circuit portion of the circuit board. The metal material constituting the second metal layer is not particularly limited, and examples thereof include aluminum, copper, iron, silver, gold, zinc, nickel, tin, and alloys containing these metals.

The thickness of the second metal layer is preferably from 0.01 to 5.0 mm, from 0.02 to 3.0 mm, and from 0.03 to 1.0 mm.

The insulating layer comprises the thermally conductive sheet described above, and may specifically be a thermally conductive sheet in the A-stage or B-stage that has been heated to become the C-stage.

The thickness of the insulating layer depends on the thickness of the thermally conductive sheet, but is preferably from 30 to 500 µm, from 50 to 300 µm, and from 80 to 200 µm. When the thickness of the insulating layer is 30 µm or more, insulation reliability tends to be further improved. When the thickness of the insulating layer is 500 µm or less, thermal resistance tends to be further reduced.

The method for producing a laminate of the present embodiment comprises a step of preparing the thermally conductive sheet described above, and a step of obtaining a laminate by press-heating the thermally conductive sheet while sandwiching it between a metal foil and a metal substrate.

The temperature in press-heating is not particularly limited, but is, for example, from 70 to 250°C, and from 120 to 180°C. The time in press-heating is not particularly limited, but is, for example, from 0.5 to 9 hours, and from 1 to 6 hours. The pressure in press-heating is not particularly limited, but is, for example, from 1 to 30 MPa, from 5 to 25 MPa, and from 8 to 20 MPa.

### 3. Circuit Board

The circuit board of the present embodiment is a printed circuit board using a metal as the base or core, and comprises a first metal layer, an insulating layer disposed on the first metal layer, and a second metal layer disposed on the insulating layer, wherein the insulating layer comprises the thermally conductive sheet described above, and the second metal layer is a circuit portion.

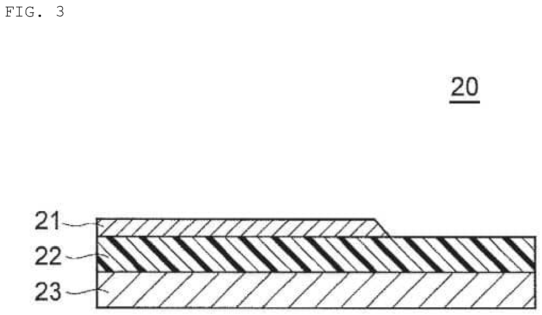

FIG. 3 shows a cross-sectional view of the circuit board of the present embodiment. As shown in FIG. 3, the circuit board 20 of the present embodiment comprises an electric circuit 21, a thermally conductive sheet 22, and a first metal layer 23 in this order. FIG. 3 shows a circuit board using a laminate for a metal base circuit board, but the circuit board of the present embodiment is not limited thereto and encompasses circuit boards using laminates for metal core circuit boards.

The thermally conductive sheet 22 and the first metal layer 23 in FIG. 3 may be the same as the thermally conductive sheet 12 and the first metal layer 13 in FIGS. 1 and 2.

The method for producing a circuit board of the present embodiment comprises a step of preparing the laminate described above, and a step of forming a circuit portion by removing part of the first metal layer or part of the second metal layer of the laminate.

### Examples

Hereinafter, the present invention will be described more specifically using examples and comparative examples. The present invention is not limited in any way by the following examples.

### (Example 1)

30 parts by mass of a bisphenol A-type epoxy resin (manufactured by DIC Corporation, EXA850CRP, epoxy equivalent 170 to 175 g/eq, hereinafter also referred to as "Bis-A-Ep"), 12 parts by mass of a bisphenol A-type novolac resin (manufactured by DIC Corporation, VH4170, OH equivalent 118 g/eq, hereinafter also referred to as "Bis-A-Nv"), 0.2 parts by mass of triphenylphosphine, 0.2 parts by mass of 1-benzyl-2-phenylimidazole (1B2PZ), 40 parts by mass of diacetone alcohol (DAA), 2.3 parts by mass of a surfactant (manufactured by Denka Company Limited, iSE-Z2), 1.2 parts by mass of an ion scavenger (iXEPLAS-B1), and a boron nitride aggregate (BN aggregate powder (T40), average particle diameter 40 µm) in an amount of 40 vol% based on the total composition were mixed.

The resulting mixture was applied onto a polyethylene terephthalate (PET) film having a thickness of 0.038 mm such that the thickness after semi-curing was 0.080 mm, and then heat-dried at 100°C for 30 minutes to prepare a thermally conductive sheet that is a semi-cured product (B-stage). The degree of cure of the obtained thermally conductive sheet was 20%.

Note that the thermally conductive sheet obtained as described above comprises epoxy resin A-bis in which X is a bisphenol A-type skeleton. Specifically, in epoxy resin A-bis, the skeleton other than the R group in the repeating unit represented by formula (1) is derived from bisphenol A-type novolac resin, and the R group represented by formula (2) is derived from bisphenol A-type epoxy resin, and the ratio (b/a) of the OH equivalent (g/eq) of bisphenol A-type novolac to the epoxy equivalent (g/eq) of bisphenol A-type epoxy was 0.60.

The obtained semi-cured product was peeled from the PET film and placed on a metal plate (copper plate with a thickness of 2.0 mm) serving as the first metal layer. Next, a metal foil (copper foil with a thickness of 0.5 mm) serving as the second metal layer was placed on the semi-cured product, and then heat-cured at 180°C for 410 minutes while applying a surface pressure of 30 kgf/cm² (3 MPa) using a press machine to obtain a laminate. The thickness of the insulating layer in the laminate was 80 µm.

Next, a predetermined position on the metal foil (second metal layer) of the laminate was masked with an etching resist, and then the copper foil was etched using a sulfuric acid-hydrogen peroxide mixed solution as an etchant. The etching resist was removed, and the product was washed and dried to obtain a metal base circuit board having a circular electrode (copper foil) with a diameter of 20 mm.

### (Example 2)

A thermally conductive sheet was obtained in the same manner as in Example 1, except that the bisphenol A-type epoxy resin (Bis-A-Ep) in Example 1 was changed to 29 parts by mass of a 1,6-naphthalenediol-type epoxy resin (manufactured by DIC Corporation, product name HP-4032D, epoxy equivalent 136 to 148 g/eq, hereinafter also referred to as "Np-Ep"). The degree of cure of the obtained thermally conductive sheet was 20%. In addition, a laminate and a metal base circuit board were obtained using the obtained thermally conductive sheet.

Note that the thermally conductive sheet obtained in Example 2 comprises epoxy resin A-Np in which X is a naphthalene skeleton. Specifically, in epoxy resin A-Np, the skeleton other than the R group in the repeating unit represented by formula (1) is derived from bisphenol A-type novolac resin, and the R group represented by formula (2) is derived from 1,6-naphthalenediol-type epoxy resin, and the ratio (b/a) of the OH equivalent (g/eq) of bisphenol A-type novolac to the epoxy equivalent (g/eq) of bisphenol A-type epoxy was 0.60.

### (Example 3)

A thermally conductive sheet was obtained in the same manner as in Example 1, except that the bisphenol A-type epoxy resin (Bis-A-Ep) in Example 1 was changed to 38.6 parts by mass of 1,6-naphthalenediol-type epoxy resin (Np-Ep), and the amount of bisphenol A-type novolac (Bis-A-Nv) used was changed to 3.2 parts by mass. The degree of cure of the obtained thermally conductive sheet was 20%. In addition, a laminate and a metal base circuit board were obtained using the obtained thermally conductive sheet.

Note that the thermally conductive sheet obtained in Example 3 comprises epoxy resin A-Np in which X is a naphthalene skeleton. Specifically, in epoxy resin A-Np, the skeleton other than the R group in the repeating unit represented by formula (1) is derived from bisphenol A-type novolac resin, and the R group represented by formula (2) is derived from 1,6-naphthalenediol-type epoxy resin, and the ratio (b/a) of the OH equivalent (g/eq) of bisphenol A-type novolac to the epoxy equivalent (g/eq) of bisphenol A-type epoxy was 0.10.

### (Example 4)

A thermally conductive sheet was obtained in the same manner as in Example 1, except that the bisphenol A-type epoxy resin (Bis-A-Ep) in Example 1 was changed to 40 parts by mass of 1,6-naphthalenediol-type epoxy resin (manufactured by DIC Corporation, product name HP-4032D, epoxy equivalent 136 to 148 g/eq, hereinafter also referred to as "Np-Ep"), and the amount of bisphenol A-type novolac (Bis-A-Nv) used was changed to 3 parts by mass. The degree of cure of the obtained thermally conductive sheet was 20%. In addition, a laminate and a metal base circuit board were obtained using the obtained thermally conductive sheet.

Note that the thermally conductive sheet obtained in Example 4 comprises epoxy resin A-Np in which X is a naphthalene skeleton. Specifically, in epoxy resin A-Np, the skeleton other than the R group in the repeating unit represented by formula (1) is derived from bisphenol A-type novolac resin, and the R group represented by formula (2) is derived from 1,6-naphthalenediol-type epoxy resin, and the ratio (b/a) of the OH equivalent (g/eq) of bisphenol A-type novolac to the epoxy equivalent (g/eq) of bisphenol A-type epoxy was 0.15.

### (Example 5)

A thermally conductive sheet was obtained in the same manner as in Example 1, except that the bisphenol A-type epoxy resin (Bis-A-Ep) in Example 1 was changed to 40 parts by mass of a 9,10-anthracenediol-type epoxy resin (manufactured by Mitsubishi Chemical Corporation, product name YX8800, epoxy equivalent 174 to 183 g/eq, hereinafter also referred to as "An-Ep"), and the amount of bisphenol A-type novolac (Bis-A-Nv) used was changed to 4 parts by mass. The degree of cure of the obtained thermally conductive sheet was 20%. In addition, a laminate and a metal base circuit board were obtained using the obtained thermally conductive sheet.

Note that the thermally conductive sheet obtained in Example 5 comprises epoxy resin A-An in which X is an anthracene skeleton. Specifically, in epoxy resin A-An, the skeleton other than the R group in the repeating unit represented by formula (1) is derived from bisphenol A-type novolac resin, and the R group represented by formula (2) is derived from 9,10-anthracenediol-type epoxy resin, and the ratio (b/a) of the OH equivalent (g/eq) of bisphenol A-type novolac to the epoxy equivalent (g/eq) of bisphenol A-type epoxy was 0.15.

### (Example 6)

A thermally conductive sheet was obtained in the same manner as in Example 1, except that the amount of bisphenol A-type epoxy resin (Bis-A-Ep) used in Example 1 was changed to 45 parts by mass, and the amount of bisphenol A-type novolac resin (Bis-A-Nv) used was changed to 30 parts by mass. The degree of cure of the obtained thermally conductive sheet was 20%. In addition, a laminate and a metal base circuit board were obtained using the obtained thermally conductive sheet.

Note that the thermally conductive sheet obtained in Example 6 comprises epoxy resin A-bis in which X is a bisphenol A-type skeleton. Specifically, in epoxy resin A-bis, the skeleton other than the R group in the repeating unit represented by formula (1) is derived from bisphenol A-type novolac resin, and the R group represented by formula (2) is derived from bisphenol A-type epoxy resin, and the ratio (b/a) of the OH equivalent (g/eq) of bisphenol A-type novolac to the epoxy equivalent (g/eq) of bisphenol A-type epoxy was 1.00.

### (Comparative Example 1)

A thermally conductive sheet was obtained in the same manner as in Example 1, except that the bisphenol A-type novolac resin in Example 1 was changed to 10 parts by mass of an aliphatic amine (manufactured by Huntsman Corporation, "D-400," amine equivalent 200). The degree of cure of the obtained thermally conductive sheet was 20%. In addition, a laminate and a metal base circuit board were obtained using the obtained thermally conductive sheet.

Note that the epoxy resin comprised in the thermally conductive sheet obtained in Comparative Example 1 has a skeleton derived from the aliphatic amine and a structure derived from ring-opening addition of bisphenol A-type epoxy resin to amine groups, and the ratio (b/a) of the amine equivalent (g/eq) of the aliphatic amine to the epoxy equivalent (g/eq) of bisphenol A-type epoxy was 0.15.

### [Degree of Cure]

Confirmation that the product was a semi-cured product (B-stage) was carried out by measuring the degree of cure using a differential scanning calorimeter (manufactured by TA Instruments, "Q2000"). Specifically, the thermally conductive sheet after the above heat drying was heated in a nitrogen atmosphere from 25 to 300°C at a heating rate of 10°C/min using a differential scanning calorimeter, and the total heat generation C₁ (cal/g) was measured. Next, the thermally conductive sheet before the above heat drying (solventevaporated product) was used as a sample, and the total heat generation C₀ (cal/g) was measured under the same conditions using a differential scanning calorimeter. Then, the degree of cure was determined by the following formula.$Degree of cure = \left({C}_{0} - {C}_{1}\right) / {C}_{0} \times 100 \left(%\right)$

### [Glass Transition Temperature]

The thermally conductive sheet in the semi-cured state (B-stage) was cut to a plate-shaped size of 0.1 mm × 5 mm × 40 mm to prepare a measurement sample, and the loss tangent (tan δ) was measured in a temperature range of 30°C to +300°C under conditions of a frequency of 10 Hz and a heating rate of 10°C/min using a dynamic viscoelasticity analyzer (manufactured by T&A Instruments, "RSA 3"), and the temperature at which the value of the loss tangent was at its maximum was taken as the glass transition temperature.

### [Insulation Reliability]

The insulation strength of the prepared laminate was measured based on JIS C 6481 using TOS 8650 (manufactured by Kikusui Electronics Corporation).

### [Peel Strength]

A copper foil cut to 10 mm × 100 mm from the prepared laminate was used, and the 90° peel strength between the copper foil and the thermally conductive sheet was measured under conditions of 23 ± 2°C and relative humidity of 50% in accordance with the method specified in JIS C 6481. The measurement was repeated 5 times, and the arithmetic mean value was taken as the peel strength.

### [Thermal Conductivity]

Thermally conductive sheets were laminated and press-molded by heat pressing to prepare a sample of 10 mm in length, 10 mm in width, and 0.5 mm in thickness, and the thermal diffusivity α was measured by the laser flash method, and the thermal conductivity λ was evaluated from the following formula. $λ = α \times Cp \times ρ$

The specific heat Cp was calculated from DSC measurements. The specific gravity ρ of the sample was measured using a specific gravity measurement kit AD-1653 (trade name) manufactured by A&D Company, Limited at a temperature of 25°C and air pressure of 1013 hPa, measuring the weight of the sample in air and in distilled water, and calculated by the following formula. $ρ = A / \left(A-B\right) \times \left({ρ}_{0}-d\right) + d$ wherein A is the mass of the sample in air, B is the mass of the sample in distilled water, ρ₀ is the density of distilled water, and d is the density of air.

### [Storage Stability 1 - Insulation Reliability]

The insulation reliability I₁ of the laminate produced after storing the thermally conductive sheet at 25°C for 1 week after fabrication, and the insulation reliability I₀ of the laminate produced immediately after fabrication of the thermally conductive sheet were measured. Then, storage stability 1 for insulation reliability was evaluated by the following formula. $Storage stability 1 = {I}_{1} / {I}_{0} \times 100$

### [Storage Stability 2 - Peel Strength]

The peel strength P₁ of the laminate produced after storing the thermally conductive sheet at 25°C for 1 week after fabrication, and the peel strength P₀ of the laminate produced immediately after fabrication of the thermally conductive sheet were measured. Then, storage stability 2 for peel strength was evaluated by the following formula. $Storage stability 2 = {P}_{1} / {P}_{0} \times 100$

**[Table 1]**

| | | Example | | | | | | Comparative Example |
|---|---|---|---|---|---|---|---|---|
| | | 1 | 2 | 3 | 4 | 5 | 6 | 1 |
| Epoxy resin (Bis-A-Ep) | parts by mass | 30 | - | - | - | - | 45 | 30 |
| Epoxy resin (Np-Ep) | parts by mass | - | 29 | 38.6 | 40 | - | - | - |
| Epoxy resin (An-Ep) | parts by mass | - | - | - | - | 40 | - | - |
| Phenol resin (Bis-A-Nv) | parts by mass | 12 | 12 | 3.2 | 3 | 4 | 30 | - |
| Aliphatic amine | parts by mass | - | - | - | - | - | - | 10 |
| Phosphorus curing accelerator (TPP) | parts by mass | 0.2 | 0.2 | 0.2 | 0.2 | 0.2 | 0.2 | - |
| Imidazole curing accelerator (1B2PZ) | parts by mass | 0.2 | 0.2 | 0.2 | 0.2 | 0.2 | - | 0.2 |
| Solvent (DAA) | parts by mass | 40 | 40 | 40 | 40 | 40 | 40 | 40 |
| In-house dispersing agent (iSE-Z2) | parts by mass | 2.3 | 2.3 | 2.3 | 2.3 | 2.3 | 2.3 | 2.3 |
| Ion scavenger (iXEPLAS-B1) | parts by mass | 1.2 | 1.2 | 1.2 | 1.2 | 1.2 | 1.2 | 1.2 |
| BN aggregate (T40) | vol% | 40 | 40 | 40 | 40 | 40 | 40 | 40 |
| Ratio (b/a) | | 0.60 | 0.60 | 0.10 | 0.15 | 0.15 | 1.00 | 0.15* |
| Glass transition temperature | [°C] | 173 | 170 | 200 | 185 | 160 | 150 | 20 |
| Insulation reliability | [kV/mm] | 55.0 | 40.0 | 45.0 | 46.0 | 42.5 | 20.0 | 15.0 |
| Peel strength | [N/cm] | 9.4 | 8.2 | 7.6 | 8.0 | 8.8 | 5.0 | 10.7 |
| Thermal conductivity | [W/m·K] | 5 | 5.2 | 5.5 | 5 | 5 | 5 | 5 |
| Storage stability 1 (insulation reliability) | % | 100 | 70 | 85 | 80 | 15 | 0 | 0 |
| Storage stability 2 (peel strength) | % | 100 | 92 | 100 | 95 | 94 | 70 | 65 |

| | | | | | | | | |
|---|---|---|---|---|---|---|---|---|
| * The ratio (b/a) of Comparative Example 1 is the ratio of the amine equivalent (g/eq) to the epoxy equivalent (g/eq). | | | | | | | | |

### Industrial Applicability

The thermally conductive sheet of the present invention has industrial applicability as a material constituting the insulating layer of a circuit board, and the like.

### Reference Signs List

10...laminate, 11...second metal layer, 12...thermally conductive sheet, 13...first metal layer, 20...circuit board, 21...electric circuit, 22...thermally conductive sheet, 23...first metal layer

## Claims

1. A thermally conductive sheet comprising:
an epoxy resin A having a repeating unit represented by the following formula (1); and
a thermally conductive filler, 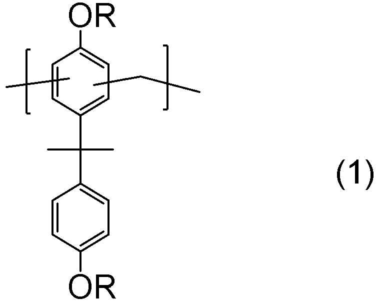
wherein R each independently represents a hydrogen atom or a group represented by the following formula (2), and at least one R represents a group represented by the following formula (2). 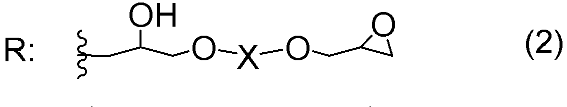
wherein X represents a divalent aryl group or a divalent bisphenol skeleton.

2. The thermally conductive sheet according to claim 1, wherein R is represented by the following formula (2a).

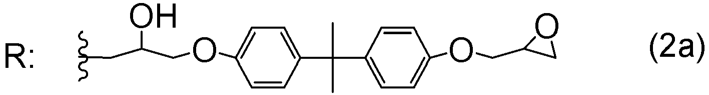

3. The thermally conductive sheet according to claim 1,
wherein the skeleton other than the R group in the repeating unit represented by formula (1) is derived from bisphenol A-type novolac resin A1, and
the R group represented by formula (2) is derived from epoxy resin A2 having a divalent aryl group or a divalent bisphenol skeleton.

4. The thermally conductive sheet according to claim 3, wherein the epoxy equivalent a of the epoxy resin A2 is from 130 to 195 g/eq.

5. The thermally conductive sheet according to claim 3, wherein the OH equivalent b of the bisphenol A-type novolac resin A1 is from 100 to 120 g/eq.

6. The thermally conductive sheet according to claim 3, wherein the ratio (b/a) of the OH equivalent b of the bisphenol A-type novolac resin A1 to the epoxy equivalent a of the epoxy resin A2 is from 0.15 to 0.90.

7. The thermally conductive sheet according to claim 1,
wherein the thermally conductive filler comprises a boron nitride aggregate.

8. A laminate comprising:
a first metal layer;
an insulating layer disposed on the first metal layer; and
a second metal layer disposed on the insulating layer,
wherein the insulating layer comprises the thermally conductive sheet according to any one of claims 1 to 7.

9. A method for producing a laminate, comprising:
a step of preparing the thermally conductive sheet according to any one of claims 1 to 7; and
a step of obtaining a laminate by press-heating the thermally conductive sheet while sandwiching the thermally conductive sheet between a metal foil and a metal substrate.

10. A circuit board comprising:
a first metal layer;
an insulating layer disposed on the first metal layer; and
a second metal layer disposed on the insulating layer,
wherein the insulating layer comprises the thermally conductive sheet according to any one of claims 1 to 6, and the second metal layer is a circuit portion.

11. A method for producing a circuit board, comprising:
a step of preparing the laminate according to claim 8; and
a step of forming a circuit portion by removing part of the first metal layer or part of the second metal layer of the laminate.
